# EUROPEAN PATENT SPECIFICATION

(11) **EP 2 333 959 B1**
(45) Date of publication and mention of the grant of the patent: **30.11.2011**
(21) Application number: 09290924.1
(22) Date of filing: 09.12.2009
(51) Int. Cl.: H03M 3/02, H03M 7/00

(54) **Look-up-table-based delta-sigma modulator**
Nachschlagetabellenbasierter Delta-Sigma-Modulator
Modulateur delta-sigma à base de tableau de consultation

(43) Date of publication of application: 15.06.2011
(73) Proprietor: Alcatel Lucent, 75008 Paris (FR)
(72) Inventor: Haslach, Christoph, 70178 Stuttgart (DE); Templ, Wolfgang, 74372 Sersheim (DE); Maier, Simone, 70565 Stuttgart (DE)
(74) Representative: Schmidt, Werner Karl

(56) References cited:
- EP-A1- 1 491 984
- US-A1- 2004 263 365

## Description

### Field of the Invention

The present invention relates to the field of signal processing, more particularly to signal conversion using Delta-Sigma modulation, in particular for use in mobile radio applications.

### Background

New power amplifier concepts for improved efficiency are based on feeding digital signals e.g. to class-S or class-D amplifiers and thus require modulators producing digital outputs, being e.g. of the Delta-Sigma type. Due to high complexity, such modulators require high implementation effort, or, even worse, they cannot be implemented for the relevant (high) output sampling rates as are required in mobile radio applications.

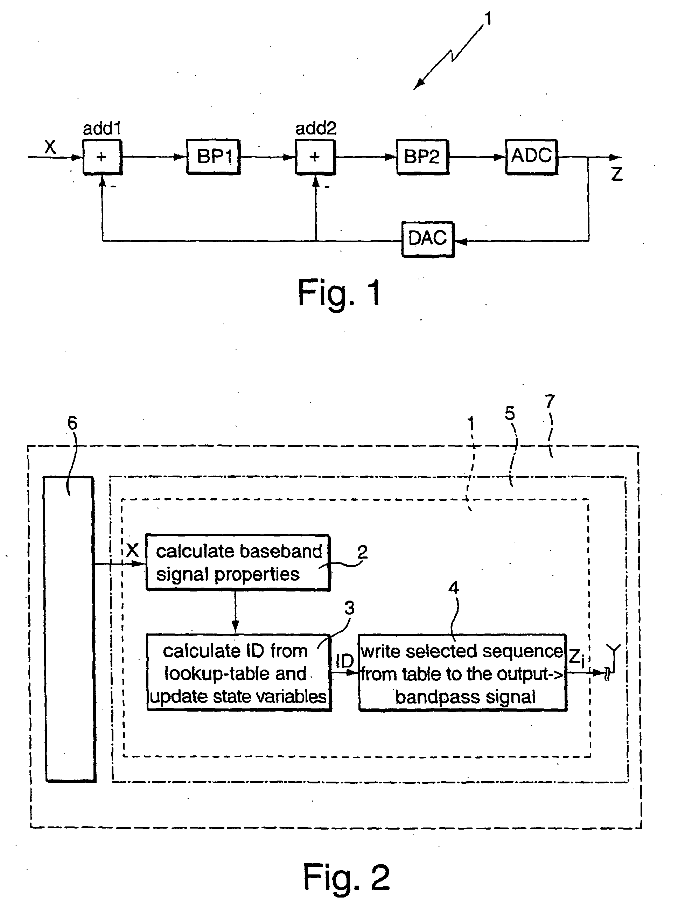

A classical band-pass Detta-Sigma modulator 1 shown in Fig. 1 comprises two band-pass filters BP1, BP2 and an analog-to-digital converter ADC for producing a Delta-Sigma modulated digital output signal Z. The Delta-Sigma modulator 1 is based on a feedback structure including a feedback path from the output of the analog-to-digital converter ADC to the inputs of the first and second band-pass filters BP1, BP2, a digital-to-analog converter DAC being provided for re-conversion of the digital feedback signal to the analog domain.

In the Delta-Sigma modulator 1 of Fig. 1, the feedback has to be fast and scales with the desired output sample rate. Hence, the feedback has a crucial impact on the clock rates and transmission rates that can be implemented. Furthermore, for the case of a band-pass Delta-Sigma modulator (BP-DSM) which is to be used in mobile radio applications, the input signal X is an RF signal being mixed up to a carrier frequency, such that extremely high sampling rates in the frequency range of the carrier frequency (in the GHz domain) are required, as the sampling rate is chosen to be an integer multiple (typically four times) the carrier frequency.

Moreover, conventional Delta-Sigma modulators are typically realized in bipolar semiconductor technologies and thus involve high power consumption. The inherent nonlinear behavior of the semiconductor components imposes constraints to signal processing system architectures. Hence, there is a need to find new, less complex, architectures for Delta-Sigma modulators.

US 2004/0263365 A1 discloses a look-up table delta-sigma modulator in which signal conversion is implemented employing a memory system operating as a look-up table that stores a plurality of sets of output samples associated with each of a plurality of respective input samples. The look-up table is adapted to generate a corresponding set of output samples in response to a given input sample, thereby emulating desired digital up-sampling and delta-sigma modulation.

### Summary of the Invention

The present invention is directed to addressing the effects of one or more of the problems set forth above.

One aspect of the invention is implemented in a Delta-Sigma-Modulator for converting a baseband signal, comprising: an input stage for generating or receiving input samples of the baseband signal at an input sampling rate, a selecting stage for selecting for each input sample a digital output sequence from a plurality of pre-calculated digital output sequences, and an output stage for generating an output signal of digital output samples from the selected digital output sequences at an output sampling rate being larger than the input sampling rate, wherein the pre-calculated digital output sequences comprise delta-sigma modulated digital output samples of the baseband signal shifted to a desired carrier frequency. Each digital output sequence is related to a spectral component of the baseband signal, and the selecting stage is adapted to select the digital output sequence from the plurality of pre-calculated digital output sequences based on a spectral component of the baseband signal.

The basic idea of the invention is to generate a Delta-Sigma modulated digital output signal by concatenating selected pre-calculated digital output sequences which are typically stored in a look-up table. For reducing the internal sampling rate of the Delta-Sigma modulator, it is proposed to use input samples of a (carrier-free) baseband signal, thus allowing to use an input sampling rate in the MHz range. The digital sequences stored in the look-up table(s) contain Delta-Sigma-modulated digital output samples of the mixed-up RF output signal, i.e., the Delta-Sigma modulator as described herein combines the functions of a classical Delta-Sigma modulator with that of a mixer for shifting the baseband signal to a carrier frequency. The input samples generated by the input stage may be derived from an analog baseband signal using analog-to-digital conversion, or, alternatively, the baseband signal may be provided as a digital signal to the input stage. In the latter case, the input stage may receive and simply forward the input samples from a digital signal processing unit which is adapted to generate a digital baseband signal.

For the (bandpass) Delta-Sigma-modulation as described herein, the deterministic aspects of the RF carrier waveform(s) can be inherently respected in the table entries. This results in a structure where all operations inside the Delta-Sigma modulator (except for the final writing of the digital samples to the output) can be executed with the low-rate baseband signal in the MHz domain instead of with the high-rate RF (bandpass) signal in the GHz domain. Exploiting deterministic signal behavior of the carrier thus yields significant complexity reduction. For example, a digital output sequence may be selected which has a spectral component at the carrier frequency which corresponds to a constant component (DC-component) of the baseband signal. In other words, when the RF output signal generated by the Delta-Sigma-Modulator is shifted back (down-converted) to the baseband level, its DC component should coincide with the DC component of the original baseband signal.

In contrast to the Delta-Sigma modulator described herein, conventional Delta-Sigma modulators for RF applications are fed with the mixed-up RF signal, thus requiring a much larger input and internal sampling rate. For example, if one assumes a baseband signal with a sampling rate of 50 MHz that has to be mixed up to a 1.25 GHz carrier frequency and will be modulated with a BP-DSM finally, this results in a input signal to the conventional BP-DSM solution with a sampling rate of 5 GHz, as the typical sampling rate for such applications is four times the carrier frequency. Thus, all operations (additions, multiplications, feedback, etc.) of the conventional band-pass Delta-Sigma modulator have to operate on the mixed-up RF signal. In contrast thereto, the Delta-Sigma modulator as described herein allows to generate the corresponding RF output signal with operations at moderate rates that are based on the 50 MHz baseband input signal. In the present case, the only device working in the 5 GHz domain is thus a simple output stage that writes the selected digital sequences to the output.

In one embodiment, the selecting stage is adapted to select the digital output sequence from the plurality of pre-calculated digital output sequences based on the an amplitude value of a currently evaluated input sample and on at least one state variable of the Delta-Sigma-Modulator, preferably normalized to a dynamic range of the baseband signal. Thus, the output sequences are selected by evaluating state variables and the amplitudes of the incoming (baseband) signal samples. As usual, the state variables are a function of the input (and output) signals which have been previously processed by the Delta-Sigma-Modulator.

In a further embodiment, the selection stage is adapted to cyclically shift the selected digital output sequence by a number of digital output samples which depends on the at least one state variable and on the currently evaluated input sample. For allowing smooth transitions between subsequent output sequences which constitute the RF output signal, a cyclic shift of the samples of the selected output sequence may be performed, leading to a phase adjustment of successive output sequences. The shifting is executed to minimize the quantization error not only at the end of the selected sequence but to achieve small quantization error values also at intermediate time instances, i.e. at time instances between start and end of the selected sequence.

In a further preferred embodiment, the state variables are measures for the quantization error of digitizing previous input samples of the baseband signal. The state variables typically represent the difference of at least one property of the input and the corresponding property of the output signal samples at the corresponding carrier frequency that have been processed up to now.

As indicated above, the digital output sequences are related to spectral components of the baseband signal. For example, the spectral component of the baseband signal may be the (constant) DC-component of the baseband signal (or any other spectral component of the baseband signal) such that the selection of the sequences may be based on the DC value of the incoming baseband signal for generating a output signal having this spectral component at the carrier frequency. It will be understood that instead of the DC-component (i.e. signal amplitude at a frequency of 0 Hz), the selection of sequences may be based on any other spectral component (amplitude at frequency f_{B}) of the baseband signal, the sequences being selected such that the resulting RF output signal has the same spectral component (amplitude) as the baseband signal, only shifted by the carrier frequency f_{C}, i.e. at a frequency f_{B} + f_{C}.

In one embodiment, the spectral component is a DC component of the baseband signal. The amplitude of the currently processed samples together with the state variables are related to the DC value of the baseband signal. As the DC value is related to the spectral component of the baseband signal at the carrier frequency, the DC value, resp., the current amplitude and the state variables may be used for selecting/addressing digital output sequences such that the resulting RF output signal has a desired spectral component at the carrier frequency.

In another embodiment, each of the pre-calculated digital output sequences is stored in a look-up table, preferably together with information about at least one property of the pre-calculated digital output sequence. (Inherent) properties of the output sequences which are stored in the look-up table may include, for example, the spectral component of the baseband signal, allowing a quick selection of the appropriate sequence based on the DC component of the baseband signal. Other properties which may be stored together with the output sequences may comprise a maximum allowed number of digital samples for the cyclical shifting outlined above. One skilled in the art will appreciate that the look-up table may be stored in a memory being devised for this purpose, e.g. in the form of a ROM or EPROM.

A further aspect of the invention relates to an active antenna element comprising a Delta-Sigma-Modulator as described above. The Delta-Sigma Modulator may in particular be used in an Envelope Tracking or Envelope Elimination and Restoration amplifier configuration, which may be arranged in an active antenna element connected to a baseband/transceiver path of a base station via appropriate cabling. Typically, the Delta-Sigma modulator is used as a first (driving) stage for a class-S or class-D power amplifier (second amplifier stage), a reconstruction filter typically forming a third amplifier stage. It will be understood that the Delta-Sigma-Modulator / amplifier configuration may also be implemented in a wireless station such as a mobile phone or a PDA.

Another aspect of the invention relates to a base station comprising a Delta-Sigma-Modulator as described above and/or an active antenna element as described above. The Delta-Sigma modulator may be arranged in the active antenna element, or, alternatively, when using conventional antenna elements, the Delta-Sigma modulator may be implemented in a digital processing unit being arranged or coupled to a baseband part of the base station.

Yet another aspect relates to a method for converting a baseband signal, comprising: generating or receiving input samples of the baseband signal at an input sampling rate, selecting for each input sample a digital output sequence from a plurality of pre-calculated digital output sequences, and generating an output signal of digital output samples from the selected digital output sequences at an output sampling rate being larger than the input sampling rate, wherein the pre-calculated digital output sequences are chosen to comprise delta-sigma modulated digital output samples of the baseband signal shifted (mixed up) to a desired carrier frequency, wherein each digital output sequence is related to a spectral component of the baseband signal, and wherein the step of selecting the digital output sequence from the plurality of pre-calculated digital output sequences is performed based on a spectral component of the baseband signal.

As outlined above, the properties of the digital output sequences and of the baseband signal are correlated, such that the step of selecting a desired digital output sequence from the plurality of pre-calculated digital output sequences can be performed based on a (signed) amplitude value of a currently evaluated input sample and on at least one state variable, the latter depending on the result(s) of digitizing previous samples of the baseband signal.

In one variant, the method further comprises the step of cyclically shifting the selected digital output sequence by a number of digital output samples depending on the at least one state variable and on the currently evaluated input sample. By performing such a cyclical shifting, a smooth transition from one digital output sequence to a subsequent digital output sequence may be performed.

In a further variant, the state variable(s) are chosen to be measure(s) for a quantization error of digitizing previous samples of the baseband signal. In particular, the state variable(s) may represent the accumulated quantization error of all previously digitized input samples.

In another variant, the spectral component is a DC value of the baseband signal. As described above, in this case, a correlation of the DC value to a desired (identical) spectral component (amplitude) at the carrier frequency of the RF output signal may be used for addressing/selecting the digital output sequences.

A person of skill in the art will readily recognize that various steps of the above-described method(s) can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of the above-described methods. The program storage devices may be, e.g., digital memories, magnetic storage media such as magnetic discs and magnetic tapes, hard drives, or optically readable digital data storage media. The embodiments are also intended to cover computers, in particular field programmable gate arrays (FPGA), application-specific integrated circuits (ASIC), or digital signal processors (DSP) programmed to perform the steps of the above-described method(s). Other hardware conventional and/or custom may also be included.

Further features and advantages are stated in the following description of exemplary embodiments, with reference to the figures of the drawing, which shows significant details.

### Brief Description of the Drawings

Exemplary embodiments are shown in the diagrammatic drawing and are explained in the description below. The following are shown:
- **Fig. 1**: shows a schematic diagram of a conventional Delta-Sigma modulator,
- **Fig. 2**: shows a schematic diagram of an embodiment of the Delta-Sigma modulator according to the invention, arranged in an active antenna element of a base station,
- **Fig. 3**: shows a schematic flow diagram of a method for digitizing a baseband signal,
- **Figs. 4a,b**: show representations of a baseband signal in the time and in the frequency domain, and
- **Figs. 5a,b**: show representations of an RF signal containing the baseband signal of Figs. 4a,b shifted to a carrier frequency.

### Detailed Description of Preferred Embodiments

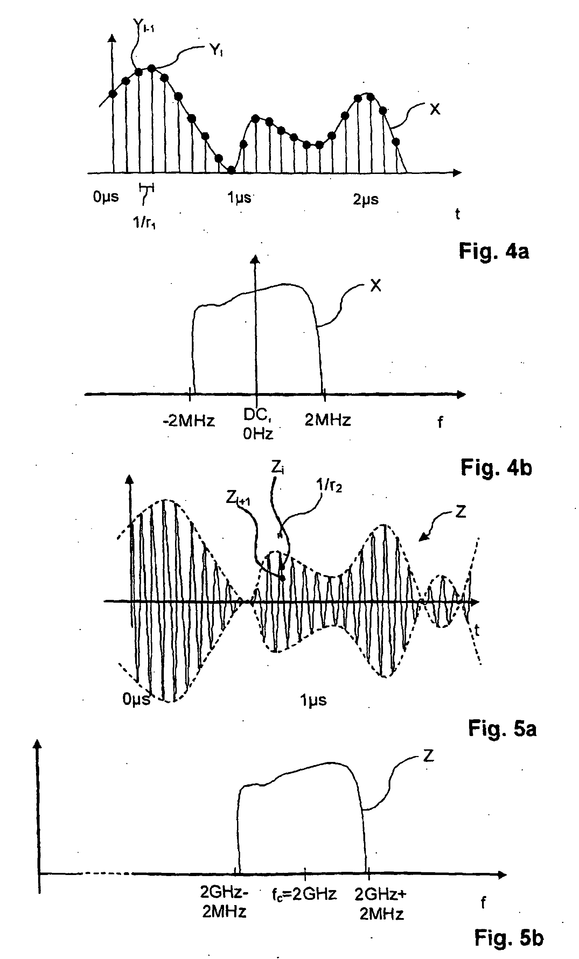

**Fig. 2** shows a table-based Delta-Sigma modulator 1 comprising an input stage **2,** a selecting stage **3,** and an output stage **4.** An analogue baseband signal **X** (see also **Figs. 4a****,b**) is fed to the input stage 2, the input stage 2 being adapted for digitizing the baseband signal X at an input sampling rate of e.g. **r1** = 10 MHz, producing a sequence of input samples **yᵢ₋₁**, **yₗ**, etc. As in the present example, the baseband signal X is a complex signal, an amplitude value of the real and imaginary part **yire, yiim** may be derived from a current input sample yᵢ of the baseband signal X in the input stage 2. The derived amplitudes yire, yiim of the current input sample yᵢ are then provided to the selecting stage 3 which selects, for the current input sample yᵢ, resp., for its real and imaginary parts yire, yiim one digital output sequence SEQre_a, SEQim_a from a plurality of pre-calculated digital output sequences SEQre, SEQim, the selection process being described in greater detail below. The output stage 4 then generates an RF output signal **zᵢ** comprising the digital output samples contained in the selected digital output sequences SEQre_a, SEQim_a. The digital samples contained in the sequences SEQre, SEQim are delta-sigma modulated samples of an RF signal **Z** (cf. **Figs. 5a****,b**) which contains the baseband signal X shifted to a carrier frequency f_{c}, having a value of 2 GHz in the present example. In the present example, the Delta-Sigma modulator 1 is arranged in an active antenna element **5,** the latter further comprising a power transistor (not shown) being e.g. of the class-S or class-D type being driven by the digital RF output signal produced by the Delta-Sigma modulator 1. The active antenna element 5 may further comprise a reconstruction filter for filtering the amplified signal before providing it to an antenna element. The active antenna element 5 forms part of a base station **7** and is connected to a baseband part **6** thereof via appropriate cabling.

As can be easily seen from the time domain representation of the RF signal Z in Fig. 5a, an envelope thereof is constituted by the baseband signal X of Fig. 4a. As the carrier of the RF signal Z oscillates at a frequency in the GHz range, i.e. at a frequency being an order of magnitude larger than the frequency of the baseband signal X, an output sampling rate **r2** in the GHz range is needed for providing Delta-Sigma modulated samples zᵢ which correctly reflect the properties of the RF signal Z. For this reason, the output stage 4 is adapted to generate the Delta-Sigma modulated samples of the output signal zᵢ at a sampling rate r2 in the GHz range. It should be noted, however, that in the Delta-Sigma modulator 1, the output stage 4 is the only stage working in the GHz domain, whereas both the input stage 2 and the selecting stage 3 may perform their operations in the MHz range. Thus, only the final write operation of copying the selected sequences SEQim_a, SEQre_a to the output has to be performed in the GHz range.

For the following calculations, it will be assumed that the output sampling rate/frequency r2 is four times the carrier frequency f_{c}, i.e. r2= 4 f_{c} = 8 GHz. The over-sampling factor of four is used in order to give an example which complies with conventional band-pass Delta-Sigma-modulator solutions. However, one skilled in the art will appreciate that the results discussed herein may be adapted for use with other over-sampling factors than four, yet being typically greater than two.

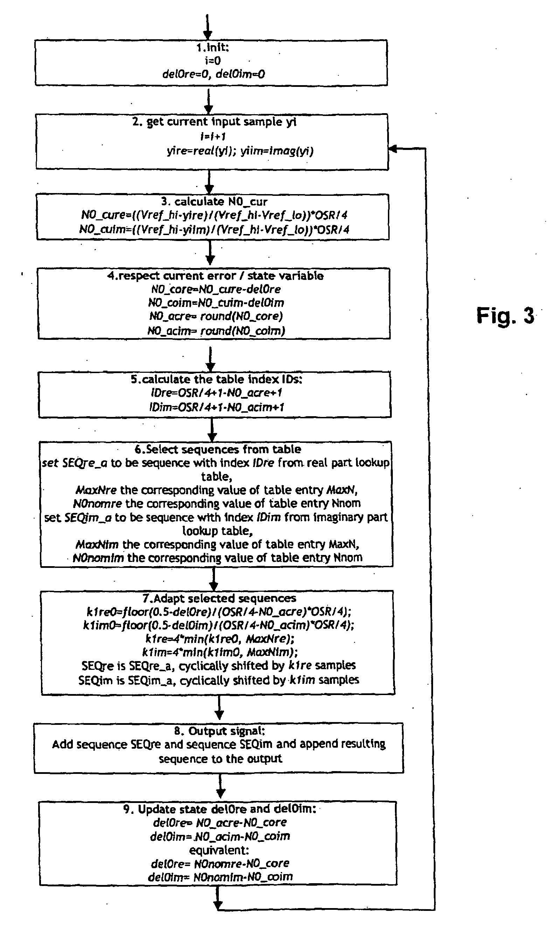

The process of digitizing the baseband signal X using the Delta-Sigma modulator 1 of Fig. 2 will be exemplified in the following with reference to Fig. 3. in a first (initialization) step, state variables **del0re**, **del0im** of the Delta-Sigma modulator 1 are set to their initial values (i.e. to zero). The state variables del0re, del0im represent an (accumulated) quantization error of the digitizing procedure, as will be explained in greater detail below.

In a second step, an input sample yᵢ (at sampling time i) of the baseband signal X is generated by the input stage 2, and the amplitudes yire, yiim of the real and imaginary part thereof are derived. In a third step, the amplitudes yire, yiim are normalized to an interval (dynamic range) between a lower bound V_ref_low and an upper bound V_ref_hi which are chosen in the present example to be V_ref_low =-1 and V_ref_hi =+1, representing the binary values of the output samples zᵢ provided to the output of the Delta-Sigma modulator 1. For calculating the normalized amplitudes N0_cure, N0_cuim of the amplitudes yire, yiim, an over-sampling factor OSR, being set to a value of 16 in the present example, has to be taken into account. The normalized amplitudes N0_cure, N0_cuim reflect the target impact of the current input signal sample yᵢ on the Direct Current value of the output signal of the Delta-Sigma modulator 1.

In order to take the state variables / the quantization error into account, the state variables del0re, del0im are subtracted from the normalized amplitude values N0_cure, N0_cuim and the resulting values N0_core, N0_coim are rounded, thus producing two values N0_acre, N0acim which can be used for indexing/selecting an appropriate digital output sequence SEQim_a, SEQre_a from the plurality of digital output sequences SEQre, SEQim. It will be understood that the number of digital samples per sequence SEQre, SEQim is 16, corresponding to the oversampling factor. The sequences SEQre related to the real part of the baseband signal X are stored in a look-up table for the real part (table 1 a) and the sequences SEQim related to the imaginary part are stored in a corresponding look-up table (table 1 b) for the imaginary part, as follows:

**table 1a**

| IDre | Sequence SEQre | | | | | | | | | | | | | | | | Property P1 | Property N0nom | MaxN |
|---|---|---|---|---|---|---|---|---|---|---|---|---|---|---|---|---|---|---|---|
| 1 | -1 | 0 | 1 | 0 | -1 | 0 | 1 | 0 | -1 | 0 | 1 | 0 | -1 | 0 | 1 | 0 | -4 | 4 | 4 |
| 2 | 1 | 0 | -1 | 0 | -1 | 0 | 1 | 0 | -1 | 0 | 1 | 0 | -1 | 0 | 1 | 0 | -2 | 3 | 3 |
| 3 | 1 | 0 | -1 | 0 | -1 | 0 | 1 | 0 | 1 | 0 | -1 | 0 | -1 | 0 | 1 | 0 | -0 | 2 | 1 |
| 4 | 1 | 0 | -1 | 0 | -1 | 0 | 1 | 0 | 1 | 0 | -1 | 0 | 1 | 0 | -1 | 0 | +2 | 1 | 1 |
| 5 | 1 | 0 | -1 | 0 | 1 | 0 | -1 | 0 | 1 | 0 | -1 | 0 | 1 | 0 | -1 | 0 | +4 | 0 | 0 |
| Comment: | | | | | | | | | | | | | | | | | | | |
| value +1 corresponds to Yref_hi | | | | | | | | | | | | | | | | | | | |
| value -1 corresponds to Vref_lo | | | | | | | | | | | | | | | | | | | |

**table 1b**

| IDim | Sequence SEQim | | | | | | | | | | | | | | | | Property P1 | Property N0nom | MaxN |
|---|---|---|---|---|---|---|---|---|---|---|---|---|---|---|---|---|---|---|---|
| 1 | 0 | -1 | 0 | 1 | 0 | -1 | 0 | 1 | 0 | -1 | 0 | 1 | 0 | -1 | 0 | 1 | -4 | 4 | 4 |
| 2 | 0 | 1 | 0 | -1 | 0 | -1 | 0 | 1 | 0 | -1 | 0 | 1 | | -1 | 0 | 1 | -2 | 3 | 3 |
| 3 | 0 | 1 | 0 | -1 | 0 | -1 | 0 | 1 | 0 | 1 | 0 | -1 | 0 | -1 | 0 | 1 | -0 | 2 | 1 |
| 4 | 0 | 1 | 0 | -1 | 0 | -1 | 0 | 1 | 0 | 1 | 0 | -1 | 0 | 1 | 0 | -1 | +2 | 1 | 1 |
| 5 | 0 | 1 | 0 | -1 | 0 | 1 | 0 | -1 | 0 | 1 | 0 | -1 | 0 | 1 | 0 | -1 | +4 | 0 | 0 |
| Comment: | | | | | | | | | | | | | | | | | | | |
| value +1 corresponds to Vref_hi | | | | | | | | | | | | | | | | | | | |
| value -1 corresponds to Vref_lo | | | | | | | | | | | | | | | | | | | |

The fact that 50% of the columns of the tables 1a,b are all-0 columns derives from the fact that the resulting oversampling factor 16 is a multiple of four in this example. As described above, this value has been chosen in order to provide a simple example for an embodiment that shows the basic ideas of the table-based delta-sigma modulator 1 as described herein.

Apart from the sequences SEQre, SEQim themselves, further properties of the sequences SEQre, SEQim are stored in the look-up tables, for example an index IDre, IDim for addressing/selecting the sequences SEQre, SEQim, or a property N0nom which represents an abstract measure of a spectral component of the baseband signal at the carrier frequency f_{c}. When splitting the Sequences SEQre and SEQim into sub-sequences of length four, N0nom counts the number of '-1 0 1 0' sub-sequences in SEQre and the number of '0 - 101' sub-sequences in SEQim. A further property referred to as P1 can be directly derived from N0nom by the following formula: P1= 4 - 2 * N0nom. P1 corresponds to the impact of the selected sequence on the frequency component at f_{c}, i.e. P1 is a direct measure for a change of the spectral component at f_{c} when the corresponding digital output sequence is appended.

Also, other properties such as a maximum number of digital samples MaxN for cyclically shifting the sequences SEQre, SEQim (see below) may be stored in the look-up tables together with the sequences SEQre, SEQim. For SEQre, MaxN denotes the number of '-1 0 10' sub-sequences in SEQim before the first '10-10' sub-sequence occurs. In a similar way, for SEQim, MaxN denotes the number of '0 -1 0 1' sub-sequences in SEQim before the first '0 1 0 -1' sub-sequence occurs.

Properties such as the index IDre, IDim, the spectral component N0nom, P1 and MaxN are inherent to the sequences SEQre, SEQim and are only stored in the look-up tables for avoiding unnecessary calculations required for deducing these properties from the sequences SEQre, SEQim.

The index value IDre, IDim of the sequence SEQre_a, SEQim_a which is to be selected is determined in a fifth step, the calculation of the index value IDre, IDim being based on the values N0_acre, N0acim which have been derived in the previous step. The index IDre, IDim is related through a one-to-one mapping to the property N0nom, the latter representing a measure of the spectral component of the corresponding baseband signal at the carrier frequency f_{c}. As the carrier signal is a deterministic signal, the index IDre, IDim can be derived from the amplitude (signed) value yᵢ of the baseband signal X in the way described herein. The table indices IDre and IDim are calculated such that |*N0cure- N0nomre*| and that |*N0cuim - N0nomim*| are minimized. It will be appreciated, however, that indexing/selecting of the sequences SEQre, SEQim may also be performed based on the property N0nom, or on other properties.

In a sixth step, the selected sequence SEQre_a, SEQim_a is read out from the respective table 1 a,b together with the property MaxN and N0nom. In a further, seventh step, the selected sequences SEQre_a, SEQim_a are shifted by a number of digital samples k1 re, k1 im being calculated from the quantities N0_acre, N0_acim and the state variables del0re, del0im, the number of shifted samples k1 re, k1im not exceeding the maximum number MaxN of the respective sequence SEQre_a, SEQim_a. The shifting is used for providing a smooth transition between subsequent selected digital sequences SEQre_a, SEQim_a which are provided to the output of the Delta-Sigma modulator 1.

In an eighth step, the sequences SEQre_a, SEQim_a, being cyclically shifted by the number of samples k1 re, k1 im are provided to the output of the Delta-Sigma modulator 1 and appended to a respective digital output sequence being determined for a precedent (complex) input sample yᵢ₋₁. For appending a single digital output sequence, the cyclically shifted sequences SEQre_a, SEQim_a, for the real and imaginary part are superimposed (added up).

In a final step (step 9), the state variables del0re, del0im are updated. As the state variables del0re, del0im represent a quantization error due to the digitizing of the input samples yᵢ, they may be expressed as the difference between the rounded value N0_acre of the value N0_core being derived from the normalized amplitude value N0_cure of the digital input sample yᵢ, i.e. del0re = N0_acre-N0_core, and del0im = N0_acim - N0_coim. As the quantities N0_acre, resp., N0_acim correspond to the property N0nom of the sequences SEQre and SEQim, respectively, the state variables may also be determined as follows: del0re = N0nomre - N0_core; del0im = N0nonim - N0_coim.

The process described above may.then be repeated for a following input sample yᵢ₊₁ by jumping back to step 2 in the flow diagram of Fig. 3. The RF output signal Z generated in the way described above has a spectral component (amplitude) at the carrier frequency f_{C} which corresponds to the amplitude of the DC component of the baseband signal.

One skilled in the art will appreciate that the implementation complexity of the flow diagram of Fig. 3 is quite low, as the operations which have to be performed are based on the baseband signal X and most operations correspond to table-lookups or fixed values (e.g. OSR/4).

One skilled in the art will readily appreciate that the simplified example described above does not imply restrictions for other implementations. For instance, depending on the over-sampling ratio and the chosen radio carrier frequency, the table sizes, the contents of the tables, the number of properties, the types of properties, as well as the number of look-up tables used may vary. The look-up tables are typically stored in a memory (e.g. an EPROM, ROM, ...) of in the Delta-Sigma modulator 1.

In summary, by following the above approach, a significant reduction of complexity (e.g. related to the sampling rate) when implementing a Delta-Sigma modulator an be achieved. The reduced complexity allows implementing the Delta-Sigma modulator for relevant applications such as radio applications which are difficult to realize or even unfeasible with Delta-Sigma modulators of the state of the art. By implementing Delta-Sigma modulators in the way described above, high output sampling rates in the GHz range which are required for radio applications may be attained, allowing implementation of Delta-Sigma modulators as a key components for new power amplifier concepts such as Class-S amplifiers.

## Claims

1. Delta-Sigma-Modulator (1) for converting a baseband signal (X), comprising:
an input stage (2) for generating or receiving input samples (yi) of the baseband signal (X) at an input sampling rate (r1),
a selecting stage (3) for selecting for each input sample (yi) a digital output sequence (SEQ) from a plurality of pre-calculated digital output sequences (SEQre, SEQim), and
an output stage (4) for generating an output signal of digital output samples (zi) from the selected digital output sequences (SEQre_a, SEQim_a) at an output sampling rate (r2) being larger than the input sampling rate (r1),
wherein the pre-calculated digital output sequences (SEQre, SEQim) comprise delta-sigma modulated digital output samples of the baseband signal (X) shifted to a desired carrier frequency (f_{c}),
**characterized in that**
each digital output sequence (SEQre, SEQim) is related to a spectral component of the baseband signal (X), and **in that** the selecting stage (3) is adapted to select the digital output sequence (SEQre_a, SEQim_a) from the plurality of pre-calculated digital output sequences (SEQre, SEQim) based on a spectral component of the baseband signal (X).

2. Delta-Sigma-Modulator according to claim 1, wherein the selecting stage (3) is adapted to select the digital output sequence (SEQre_a, SEQim_a) from the plurality of pre-calculated digital output sequences (SEQre, SEQim) based on an amplitude value (yire, yiim) of a currently evaluated input sample (yi), preferably normalized to a dynamic range of the baseband signal (X), and on at least one state variable (del0re, del0im) of the Delta-Sigma-Modulator (1).

3. Delta-Sigma-Modulator according to claim 2, wherein the selection stage (3) is adapted to cyclically shift the selected digital output sequence (SEQre_a, SEQim_a) by a number (k1 re, k1 im) of digital output samples which depends on the at least one state variable (del0re, del0im) and on the currently evaluated input sample (yᵢ).

4. Delta-Sigma-Modulator according to claim 2, wherein the state variables (del0re, del0im) are measures for the quantization error of digitizing previous input samples (yᵢ₋₁, ...) of the baseband signal (X).

5. Delta-Sigma-Modulator according to claim 1, wherein the spectral component is a DC component of the baseband signal (X).

6. Delta-Sigma-Modulator according to claim 1, wherein each of the pre-calculated digital output sequences (SEQre, SEQim) is stored in a look-up table, preferably together with information about at least one property (IDre, IDim; N0nomre, N0nomim; MaxN) of the pre-calculated digital output sequence (SEQre, SEQim).

7. Active antenna element (5) comprising a Delta-Sigma-Modulator (1) according to claim 1.

8. Base station (7) comprising a Delta-Sigma-Modulator (1) according to claim 1 and/or an active antenna element (5) according to claim 8.

9. Method for converting a baseband signal (X), comprising:
generating or receiving input samples (yi) of the baseband signal (X) at an input sampling rate (r1),
selecting for each input sample (yi) a digital output sequence (SEQre_a, SEQim_a) from a plurality of pre-calculated digital output sequences (SEQre, SEQim), and
generating an output signal of digital output samples (zᵢ) from the selected digital output sequences (SEQre_a, SEQim_a) at an output sampling rate (r2) being larger than the input sampling rate (r1),
wherein the pre-calculated digital output sequences (SEQre, SEQim) are chosen to comprise delta-sigma modulated digital output samples of the baseband signal (X) shifted to a desired carrier frequency (f_{c}),
**characterized in that**
each digital output sequence (SEQre, SEQim) is related to a spectral component of the baseband signal (X), and **in that** the step of selecting the digital output sequence (SEQre_a, SEQim_a) from the plurality of pre-calculated digital output sequences (SEQre, SEQim) is performed based on a spectral component of the baseband signal (X).

10. Method according to claim 9, wherein the step of selecting the digital output sequence (SEQre_a, SEQim_a) from the plurality of pre-calculated digital output sequences (SEQre, SEQim) is performed based on an amplitude value (yire, yiim) of a currently evaluated input sample (yi) and on at least one state variable (del0re, del0im) depending on the result of digitizing previous samples (yᵢ₋₁, ...) of the baseband signal (X).

11. Method according to claim 10, further comprising the step of cyclically shifting the selected digital output sequence (SEQre_a, SEQim_a) by a number (k1re, k1im) of digital output samples depending on the at least one state variable (del0re, del0im) and on the currently evaluated input sample (yi).

12. Method according to claim 10, wherein the state variables (del0re, del0im) are chosen to be measures for a quantization error of digitizing previous samples (yᵢ₋₁, ...) of the baseband signal (X).

13. Method according to claim 9, wherein the spectral component is a DC component of the baseband signal (X).

## Patentansprüche

1. Delta-Sigma-Modulator (1) zur Umwandlung eines Basisbandsignals (X), umfassend:
Eine Eingangsstufe (2) zum Erzeugen oder Empfangen von Eingangsabtastungen (yi) des Basisbandsignals (X) mit einer Eingangsabtastrate (r1),
eine Auswahlstufe (3) zum Auswählen, für jede Eingangsabtastung (yi), einer digitalen Ausgangssequenz (SEQ) aus einer Mehrzahl von vorausberechneten digitalen Ausgangssequenzen (SEQre, SEQim), und
eine Ausgangsstufe (4) zum Erzeugen eines Ausgangssignals von digitalen Ausgangsabtastungen (zi) aus den ausgewählten digitalen Ausgangssequenzen (SEQre_a, SEQim_a) mit einer Ausgangsabtastrate (r2), welche höher ist als die Eingangsabtastrate (r1),
wobei die vorausberechneten digitalen Ausgangssequenzen (SEQre, SEQim) in eine gewünschte Trägerfrequenz (f_{c}) verschobene delta-sigma-modulierte digitale Ausgangsabtastungen des Basisbandsignals (X) enthalten,
**dadurch gekennzeichnet, dass**
eine jede digitale Ausgangssequenz (SEQre, SEQim) eine spektrale Komponente des Basisbandsignals (X) betrifft, und dass die Auswahlstufe (3) dafür geeignet ist, die digitale Ausgangssequenz (SEQre_a, SEQim_a) aus der Mehrzahl von vorausberechneten digitalen Ausgangssequenzen (SEQre, SEQim) auf der Basis einer spektralen Komponente des Basisbandsignals (X) auszuwählen.

2. Delta-Sigma-Modulator nach Anspruch 1, wobei die Auswahlstufe (3) dafür geeignet ist, die digitale Ausgangssequenz (SEQre_a, SEQim_a) aus der Mehrzahl von vorausberechneten digitalen Ausgangssequenzen (SEQre, SEQim) auf der Basis eines Amplitudenwertes (yire, yiim) einer momentan bewerteten Eingangsabtastung (yi), vorzugsweise auf einen Dynamikbereich des Basisbandsignals (X) normalisiert, und mindestens einer Zustandsvariablen (del0re, del0im) des Delta-Sigma-Modulators (1) auszuwählen.

3. Delta-Sigma-Modulator nach Anspruch 2, wobei die Auswahlstufe (3) dafür geeignet ist, die ausgewählte digitale Ausgangssequenz (SEQre_a, SEQim_a) zyklisch um eine Anzahl (k1re, k1im) von digitalen Ausgangsabtastungen, welche von der mindestens einen Zustandsvariablen (del0re, del0im) und von der momentan bewerteten Eingangsabtastung (yi) abhängt, zu verschieben.

4. Delta-Sigma-Modulator nach Anspruch 2, wobei die Zustandsvariablen (del0re, del0im) Messungen für den Quantisierungsfehler bei der Digitalisierung vorheriger Eingangsabtastungen (yᵢ₋₁, ...) des Basisbandsignals (X) sind.

5. Delta-Sigma-Modulator nach Anspruch 1, wobei die spektrale Komponente eine DC-Komponente des Basisbandsignals (X) ist.

6. Delta-Sigma-Modulator nach Anspruch 1, wobei eine jede der vorausberechneten digitalen Ausgangssequenzen (SEQre, SEQim) in einer Lookup-Tabelle, vorzugsweise zusammen mit Informationen in Bezug auf mindestens eine Eigenschaft (IDre, IDim; N0nomre, N0nomim; MaxN) der vorausberechneten digitalen Ausgangssequenz (SEQre, SEQim), gespeichert wird.

7. Aktives Antennenelement (5) mit einem Delta-Sigma-Modulator (1) gemäß Anspruch 1.

8. Basisstation (7) mit einem Delta-Sigma-Modulator (1) gemäß Anspruch 1 und/oder einem aktiven Antennenelement (5) gemäß Anspruch 7.

9. Verfahren zur Umwandlung eines Basisbandsignals (X), umfassend:
Erzeugen oder Empfangen von Eingangsabtastungen (yi) des Basisbandsignals (X) mit einer Eingangsabtastrate (r1),
Auswählen, für jede Eingangsabtastung (yi), einer digitalen Ausgangssequenz (SEQre_a, SEQim_a) aus einer Mehrzahl von vorausberechneten digitalen Ausgangssequenzen (SEQre, SEQim), und
Erzeugen eines Ausgangssignals von digitalen Ausgangsabtastungen (zᵢ) aus den ausgewählten digitalen Ausgangssequenzen (SEQre_a, SEQim_a) mit einer Ausgangsabtastrate (r2), welcher höher ist als die Eingangsabtastrate (r1),
wobei die vorausberechneten digitalen Ausgangssequenzen (SEQre, SEQim) derart ausgewählt werden, dass sie in eine gewünschte Trägerfrequenz (f_{c}) verschobene delta-sigma-modulierte digitale Ausgangsabtastungen des Basisbandsignals (X) enthalten, **dadurch gekennzeichnet, dass** jede digitale Ausgangssequenz (SEQre, SEQim) eine spektrale Komponente des Basisbandsignals (X) betrifft, und dass der Schritt des Auswählens der digitalen Ausgangssequenz (SEQre_a, SEQim_a) aus der Mehrzahl von vorausberechneten digitalen Ausgangssequenzen (SEQre, SEQim) auf der Basis einer spektralen Komponente des Basisbandsignals (X) durchgeführt wird.

10. Verfahren nach Anspruch 9, wobei der Schritt des Auswählens der digitalen Ausgangssequenz (SEQre_a, SEQim_a) aus der Mehrzahl von vorausberechneten digitalen Ausgangssequenzen (SEQre, SEQim) auf der Basis eines Amplitudenwertes (yire, yiim) einer momentan bewerteten Eingangsabtastung (yi) und mindestens einer Zustandsvariablen (del0re, del0im) in Abhängigkeit von dem Ergebnis der Digitalisierung vorheriger Abtastungen (yᵢ₋₁, ...) des Basisbandsignals (X) durchgeführt wird.

11. Verfahren nach Anspruch 10, weiterhin umfassend den Schritt des zyklischen Verschiebens der ausgewählten digitalen Ausgangssequenz (SEQre_a, SEQim_a) um eine Anzahl (k1re, k1im) von digitalen Ausgangsabtastungen in Abhängigkeit von der mindestens einen Zustandsvariablen (del0re, del0im) und von der momentan bewerteten Eingangsabtastung (yi).

12. Verfahren nach Anspruch 10, wobei die Zustandsvariablen (del0re, del0im) als Messungen für einen Quantisierungsfehler bei der Digitalisierung vorheriger Abtastungen (yᵢ₋₁, ...) des Basisbandsignals (X) ausgewählt werden.

13. Verfahren nach Anspruch 9, wobei die spektrale Komponente eine DC-Komponente des Basisbandsignals (X) ist.

## Revendications

1. Modulateur Delta-Sigma (1) pour convertir un signal en bande de base (X), comprenant :
un étage d'entrée (2) pour générer ou recevoir des échantillons d'entrée (yi) du signal en bande de base (X) à une vitesse d'échantillonnage d'entrée (r1),
un étage de sélection (3) pour sélectionner pour chaque échantillon d'entrée (yi) une séquence numérique de sortie (SEQ) à partir d'une pluralité de séquences numériques de sortie (SEQre, SEQim) pré-calculées, et
un étage de sortie (4) pour générer un signal de sortie d'échantillons numériques de sortie (zi) à partir des séquences numériques de sortie (SEQre_a, SEQim_a) sélectionnées à une vitesse d'échantillonnage de sortie (r2) plus importante que la vitesse d'échantillonnage d'entrée (r1),
dans lequel les séquences numériques de sortie (SEQre, SEQim) pré-calculées comprennent des échantillons numériques de sortie modulés delta-sigma du signal en bande de base (X) décalé vers une fréquence porteuse souhaitée (f_{c}),
**caractérisé en ce que**
chaque séquence numérique de sortie (SEQre, SEQim) est liée à une composante spectrale du signal en bande de base (X), et **en ce que** l'étage de sélection (3) est adapté pour sélectionner la séquence numérique de sortie (SEQre_a, SEQim_a) à partir de la pluralité de séquences numériques de sortie (SEQre, SEQim) pré-calculées sur la base d'une composante spectrale du signal en bande de base (X).

2. Modulateur Delta-Sigma selon la revendication 1, dans lequel l'étage de sélection (3) est adapté pour sélectionner la séquence numérique de sortie (SEQre_a, SEQim_a) à partir de la pluralité de séquences numériques de sortie (SEQre, SEQim) pré-calculées sur la base d'une valeur d'amplitude (yire, yiim) d'un échantillon d'entrée (yi) actuellement évalué, de préférence normalisée dans une plage dynamique du signal en bande de base (X), et sur la base d'au moins une variable d'état (del0re, del0im) du modulateur Delta-Sigma (1).

3. Modulateur Delta-Sigma selon la revendication 2, dans lequel l'étage de sélection (3) est adapté pour le décalage cyclique de la séquence numérique de sortie (SEQre_a, SEQim_a) sélectionnée selon un nombre (k1re, k1im) d'échantillons numériques de sortie qui dépend de l'au moins une variable d'état (del0re, del0im) et de l'échantillon d'entrée (yᵢ) actuellement évalué.

4. Modulateur Delta-Sigma selon la revendication 2, dans lequel les variables d'état (del0re, del0im) sont des mesures pour l'erreur de quantification de numérisation d'échantillons d'entrée précédents (yᵢ₋₁, ...) du signal en bande de base (X).

5. Modulateur Delta-Sigma selon la revendication 1, dans lequel la composante spectrale est une composante CC du signal en bande de base (X).

6. Modulateur Delta-Sigma selon la revendication 1, dans lequel chacune des séquences numériques de sortie (SEQre, SEQim) pré-calculées est stockée dans un tableau de consultation, de préférence avec des informations concernant au moins une propriété (IDre, IDim ; N0nomre, N0nomim ; MaxN) de la séquence numérique de sortie (SEQre, SEQim) pré-calculée.

7. Élément d'antenne actif (5) comprenant un modulateur Delta-Sigma (1) selon la revendication 1.

8. Station de base (7) comprenant un modulateur Delta-Sigma (1) selon la revendication 1 et/ou un élément d'antenne actif (5) selon la revendication 7.

9. Procédé de conversion d'un signal en bande de base (X), comprenant les étapes suivantes :
générer ou recevoir des échantillons d'entrée (yi) du signal en bande de base (X) à une vitesse d'échantillonnage d'entrée (r1),
sélectionner pour chaque échantillon d'entrée (yi) une séquence numérique de sortie (SEQre_a, SEQim_a) à partir d'une pluralité de séquences numériques de sortie (SEQre, SEQim) pré-calculées, et
générer un signal de sortie d'échantillons numériques de sortie (zᵢ) à partir des séquences numériques de sortie (SEQre_a, SEQim_a) sélectionnées à une vitesse d'échantillonnage de sortie (r2) plus importante que la vitesse d'échantillonnage d'entrée (r1 ),
dans lequel les séquences numériques de sortie (SEQre, SEQim) pré-calculées sont choisies pour comprendre des échantillons numériques de sortie modulés delta-sigma du signal en bande de base (X) décalé vers une fréquence porteuse souhaitée (f_{c}), **caractérisé en ce que**
chaque séquence numérique de sortie (SEQre, SEQim) est liée à une composante spectrale du signal en bande de base (X), et **en ce que** l'étape de sélection de la séquence numérique de sortie (SEQre_a, SEQim_a) à partir de la pluralité de séquences numériques de sortie (SEQre, SEQim) pré-calculées est réalisée sur la base d'une composante spectrale du signal en bande de base (X).

10. Procédé selon la revendication 9, dans lequel l'étape de sélection de la séquence numérique de sortie (SEQre_a, SEQim_a) à partir de la pluralité de séquences numériques de sortie (SEQre, SEQim) pré-calculées est réalisée sur la base d'une valeur d'amplitude (yire, yiim) d'un échantillon d'entrée (yi) actuellement évalué sur la base d'au moins une variable d'état (delOre, delOim) en fonction du résultat de la numérisation d'échantillons précédents (yᵢ₋₁, ...) du signal en bande de base (X).

11. Procédé selon la revendication 10, comprenant en outre l'étape de décalage cyclique de la séquence numérique de sortie (SEQre_a, SEQim_a) sélectionnée selon un nombre (k1re, k1im) d'échantillons numériques de sortie dépendant de l'au moins une variable d'état (del0re, del0im) et de l'échantillon d'entrée (yi) actuellement évalué.

12. Procédé selon la revendication 10, dans lequel les variables d'état (del0re, del0im) sont choisies en tant que mesures pour une erreur de quantification de numérisation d'échantillons précédents (yᵢ₋₁, ...) du signal en bande de base (X).

13. Procédé selon la revendication 9, dans lequel la composante spectrale est une composante CC du signal en bande de base (X).
